# FASCICULE DE BREVET EUROPEEN

(11) **EP 1 797 587 B1**
(45) Date de publication et mention de la délivrance du brevet: **30.09.2015**
(21) Numéro de dépôt: 05810739.2
(22) Date de dépôt: 06.10.2005
(51) Int. Cl.: H01L 21/762

(54) **PROCEDE D'ELABORATION DE STRUCTURES EMPILEES MIXTES, A ZONES ISOLANTES DIVERSES ET/OU ZONES DE CONDUCTION ELECTRIQUE VERTICALE LOCALISEES**
VERFAHREN ZUR ERZEUGUNG GEMISCHTER SCHICHTSTRUKTUREN MIT MEHREREN ISOLIERUNGSZONEN UND/ODER VERTIKAL ANGEORDNETEN ELEKTRISCH LEITENDEN ZONEN
METHOD FOR PROVIDING MIXED STACKED STRUCTURES, WITH VARIOUS INSULATING ZONES AND/OR ELECTRICALLY CONDUCTING ZONES VERTICALLY LOCALIZED

(30) Priorité: 06.10.2004 FR 0452283
(43) Date de publication de la demande: 20.06.2007
(73) Titulaire: Commissariat à l'Énergie Atomique et aux Énergies Alternatives, 75015 Paris (FR)
(72) Inventeur: MORICEAU, Hubert, F-38120 SAINT EGREVE (FR); MORALES, Christophe, F-38220 VIZILLE (FR); ZUSSY, Marc, F-38120 SAINT EGREVE (FR); DECHAMP, Jérôme, 38140 Beaucroissant (FR)
(74) Mandataire: Ahner, Philippe
(86) Numéro de dépôt international: PCT/FR2005/050825
(87) Numéro de publication internationale: WO 2006/037933

(56) Documents cités:
- WO-A-2004/044975
- FR-A- 2 830 681
- US-A- 5 238 865
- US-A- 6 027 958

## Description

### DOMAINE TECHNIQUE ET ART ANTÉRIEUR

L'invention concerne le domaine des structures de type semi-conducteur sur isolant, comme par exemple les structures silicium sur isolant également dénommées SOI.

Dans ces technologies un substrat de matériau, en général semi-conducteur, supporte un film d'isolant enterré, par exemple en dioxyde de silicium, et un film de matériau semi-conducteur superficiel.

La réalisation de telles structures semi-conducteur sur isolant est possible par plusieurs technologies, telles que par exemple décrites dans le livre de Q. Y. Tong et U. Gösele, « Semiconductor wafer bonding, Science and technology », Ed. The Electrochemical Society Series, 1999 :
- par des procédés basés sur l'implantation d'oxygène dans du matériau semi-conducteur et un ou des traitement (s) thermique (s) à haute température (procédés de type SIMOX),
- par des procédés basés sur le collage moléculaire et avec, par exemple, soit :
   - un amincissement mécanique et/ou chimique (procédés de type BSOI),
   - un amincissement mécanique et une attaque chimique avec arrêt sur une couche sacrificielle (procédés de type BESOI),
   - une réalisation, préalable au collage moléculaire, d'une ou plusieurs zone (s) poreuse (s) de fragilisation en vue d'une séparation ultérieure,
   - une implantation préalable au collage moléculaire d'espèces gazeuses dans une plaque de semi-conducteur pour y générer une zone fragilisée en vue d'une fracture ultérieur.

Le document US 5 238 865 divulgue la possibilité de réaliser des plaquettes de silicium structurées en surface, de telle façon que des zones comportant par exemple des oxydes épais alternent avec des zones d'oxyde fin ou bien que des zones d'oxydes alternent avec des zones sans oxyde, c'est-à-dire en silicium vierge.

L'invention concerne principalement le domaine des procédés basés sur le collage moléculaire et des structures réalisées par de tels procédés.

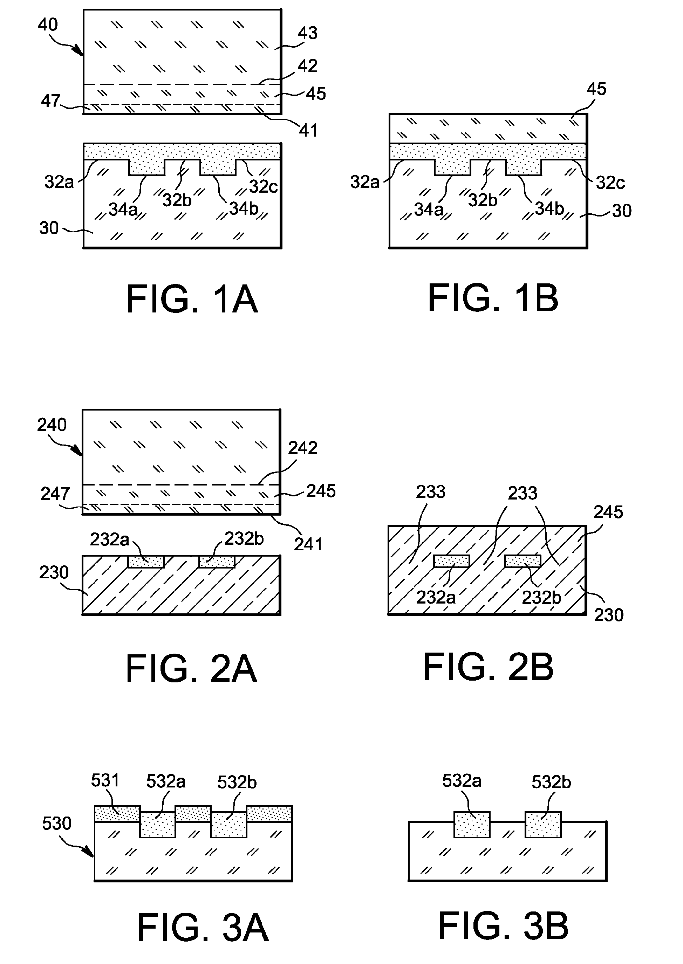

Divers besoins se sont exprimés :
1) La possibilité d'avoir dans une même structure semi-conductrice 230, illustrée en figure 2B, des zones 233 avec une conduction verticale (analogue dans son comportement à un semi-conducteur massif, épitaxié etc...), qui séparent des zones 232a, 232b isolées verticalement électriquement du substrat,
2) La possibilité d'avoir, comme illustré sur la figure 1B, localement des SOI 30 à zones d'oxyde enterré 32a, 32b, 32c très fins et des SOI à zones 34a, 34b d'oxyde enterré plus épais.
3) La possibilité d'avoir localement des zones de conduction verticale, des zones de SOI à oxydes enterrés fins, et des zones de SOI avec des oxydes enterrés plus épais et des épaisseurs variables.
4) La possibilité d'avoir des SOI avec plus que deux épaisseurs d'oxyde enterré.

Le document FR-2847077 divulgue la possibilité de réaliser des plaquettes de silicium structurées en surface, de telle façon que des zones comportant par exemple des oxydes épais 34a, 34b (figure 1A) alternent avec des zones d'oxyde fin 32a, b, c, ou bien que des zones d'oxydes 232a, 232b alternent avec des zones 233 sans oxyde, c'est-à-dire en silicium vierge (figure 2A).

Selon un exemple de procédé décrit dans le document FR - 2 847 077, on réalise, dans un premier substrat 30 semi-conducteur (on prendra l'exemple du silicium) des zones ou couches isolantes (on prendra l'exemple de l'oxyde de silicium SiO₂) 32a, 32b, 32c, 34a, 34b ayant des épaisseurs différentes. Différentes techniques peuvent être mises en oeuvre pour la réalisation de ces zones isolantes. Elles seront décrites plus loin, en liaison avec les figures 3A et suivantes.

De telles plaques structurées peuvent être alors collées par collage moléculaire sur des plaques 40 de silicium vierge ou sur des plaques de silicium oxydé, dont la couche 47 d'oxyde est d'épaisseur faible.

Plus précisément, dans le deuxième substrat semi-conducteur 40 est réalisée une implantation atomique ou ionique, formant une mince couche 42 qui s'étend sensiblement parallèlement à une surface 41 du substrat 40. En fait est ainsi formée une couche ou un plan de fragilisation ou de fracture délimitant, dans le volume du substrat 40, une région inférieure 45 destinée à constituer un film mince et une région supérieure 43 constituant la masse du substrat 40. Cette implantation est en général une implantation d'hydrogène, mais peut être aussi faite à l'aide d'autres espèces, ou encore avec une co-implantation H/He.

Les deux substrats 30 et 40 ainsi préparés sont ensuite assemblés par une technique de type "wafer bonding" ou par contact de type adhérent par exemple par adhésion moléculaire ou par collage. On pourra se reporter, en ce qui concerne ces techniques, à l'ouvrage de Q.Y. Tong et U. Gosele «Semiconductor Wafer Bonding » (Science and Technology), Wiley Interscience Publications.

Une partie du substrat 40 est ensuite détachée par un traitement permettant de provoquer une fracture le long du plan de fragilisation 42. Un exemple de cette technique est décrit dans l'article de A.J. Auberton-Hervé et al. « Why can Smart-Cut change the future of microelectronics ? » paru dans International Journal of High Speed Electronics and Systems, Vol. 10, N°.1 (2000), p. 131-146.

Est ainsi formé un composant ou un élément semi-conducteur, ou une structure semi-conductrice conforme à la figure 1B.

Selon encore un autre mode de réalisation illustré sur les figures 2A et 2B, un premier substrat est un substrat 230 semi-conducteur (par exemple : de silicium) brut dans lequel des zones d'isolant (par exemple : SiO2) 232a, 232b sont réalisées à côté de zones de silicium brut.

Dans un deuxième substrat 240, on crée par implantation atomique ou d'ions, par exemple d'ions hydrogène, une couche de fragilisation 242 similaire à la couche 42 décrite ci-dessus. Cette couche de fragilisation délimite, dans le volume du substrat 240, la couche mince 245.

Les deux substrats 230 et 240 ainsi préparés sont ensuite assemblés par une des techniques déjà mentionnées ci-dessus ("wafer bonding" ou collage ou contact de type adhérent, par exemple par adhésion moléculaire).

La partie du substrat 240, située du côté opposé à la face 241 d'assemblage des substrats, est ensuite éliminée ou détachée, comme déjà décrit ci-dessus en liaison avec la figure 1B.

Est ainsi formé un composant ou un élément semi-conducteur ou une structure semi-conductrice mixte planaire selon la structure de la figure 2B, présentant une alternance (ou toute autre forme de juxtaposition ou de répartition) de zones 232a, 232b d'isolant (ici : d'oxyde SiO2), pouvant avoir des épaisseurs différentes l'une de l'autre et de zones de semi-conducteur ou de silicium brut.

Divers composants électroniques peuvent ensuite être réalisés dans les couches superficielles 45, 245 de semi-conducteur ou de silicium, notamment dans la partie de la couche située au-dessus des zones d'isolant ou d'oxyde de silicium.

L'obtention des structures telles que le substrat 30 de la figure 1A et le substrat 230 de la figure 2A, selon l'enseignement du document FR 2 847 077, fait notamment intervenir les étapes suivantes, illustrées en figures 3A - 3E ou 4A - 4C.

Sur la figure 3A des zones 532 a, 532b de dioxyde de silicium sont réalisées sur un substrat 530 par croissance par procédé LOCOS ("Locally Oxide Silicon", ou oxydation locale du silicium) à travers un masque 531. Ces zones peuvent avoir la forme de pastilles ou de bandes ou des formes plus complexes.

Le masque est ensuite enlevé (figure 3B), laissant subsister les zones 532a, 532b d'oxyde de silicium.

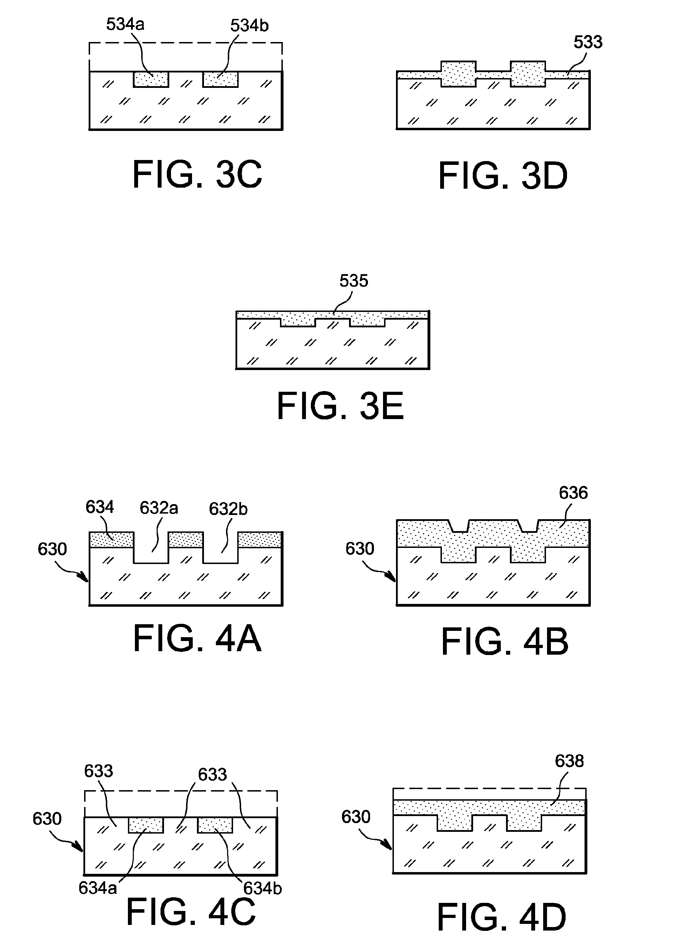

Une étape de planarisation par polissage mécano-chimique (figure 3C) est ensuite réalisée, ce qui conduit à un substrat présentant des zones 534a, b de dioxyde de silicium juxtaposées au silicium du substrat lui-même. Ce substrat est par exemple celui utilisé sur la figure 2A.

Selon une variante (figure 3D), une couche 533 d'oxydation superficielle du substrat est réalisée à partir de la structure de la figure 3B puis (figure 3E) l'ensemble est planarisé par polissage mécano-chimique, pour laisser une couche 535 d'oxydation superficielle.

Une couche de quelques centaines de nm (par exemple 300 nm) peut ainsi être enlevée, laissant subsister une juxtaposition de zones de dioxyde de silicium d'épaisseurs différentes. Ce type de substrat est utilisé dans la figure 1A ci-dessus.

Un autre procédé pouvant être mis en oeuvre illustré en figures 4A - 4C.

Sur la figure 4A des tranchées 632 a, 632b sont gravées, par exemple par gravure sèche à travers un masque 634, dans un substrat de silicium 630.

Le masque est ensuite enlevé (figure 4B), puis le substrat est oxydé thermiquement en surface, ou bien une couche de dioxyde de silicium est déposée, formant une couche 636 de dioxyde de silicium.

Une étape de planarisation par polissage mécano-chimique (figure 4C) est ensuite réalisée, ce qui conduit à un substrat présentant des zones 634a, b de dioxyde de silicium juxtaposées au silicium 633 du substrat lui-même. Ce substrat est par exemple celui utilisé sur la figure 2B.

Selon une variante (figure 4D), l'ensemble de la figure 4B est aplani, mais moins que dans le cas de la figure 4C, laissant subsister une couche 638 de dioxyde de silicium. Est ainsi réalisée une juxtaposition de zones de dioxyde de silicium d'épaisseurs différentes en surface du substrat de silicium 630. Ce type de substrat est utilisé dans la figure 1A ci-dessus.

Pour résumer, ces techniques mettent en oeuvre :
- une première étape de lithographie pour réaliser un masque (par exemple de nitrure) en vue d'une oxydation localisée de la plaque,
- une seconde étape d'oxydation des zones ouvertes dans le masque (figure 3A), et éventuellement également des autres zones (figure 4B), par traitement thermique oxydant,
- une troisième étape de réduction de la topologie de surface par une technique de polissage mécano chimique. Cette étape est arrêtée en fonction de la structure à réaliser, selon que l'on cherche à obtenir, à la surface de la plaque de silicium, une alternance de zones avec un oxyde fin et de zones avec un oxyde plus épais, ou une alternance de silicium vierge et d'oxyde de silicium.

Quel que soit celui de ces procédés qui est mis en oeuvre, il nécessite un amincissement par un polissage mécano-chimique, qui s'avère être une étape critique.

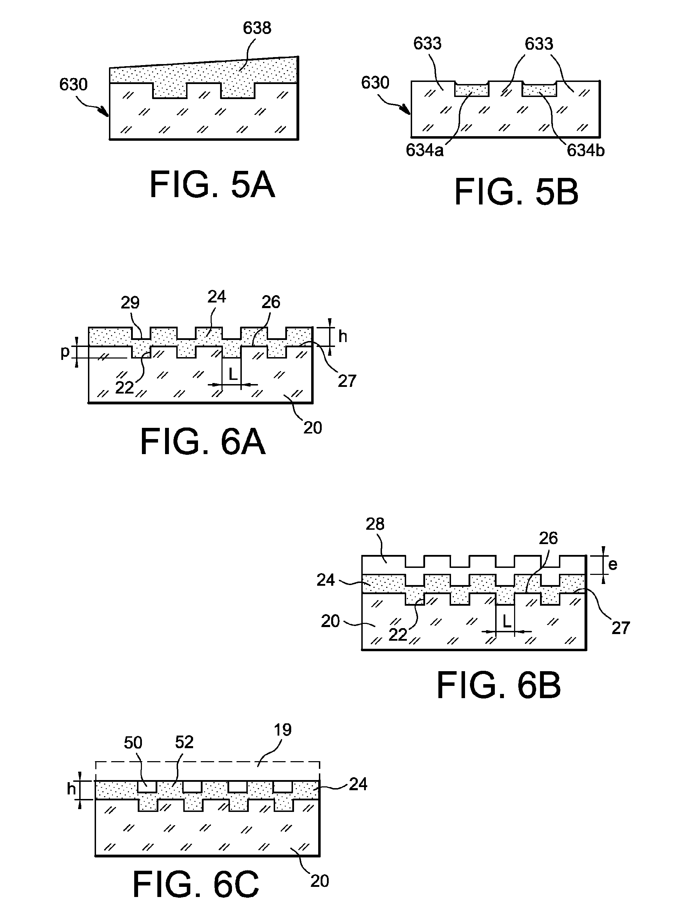

Comme illustré en figure 5A, cette étape peut induire un défaut d'homogénéité d'épaisseur en divers points de la plaque. Ce défaut d'homogénéité est proportionnel en particulier à l'épaisseur enlevée.

Ce problème est rencontré dès lors qu'un substrat tel que celui de la figure 3B ou 3D ou celui de la figure 4B est soumis à un polissage mécano-chimique.

Il est donc difficile, avec cette technique d'amincissement par polissage, de trouver des conditions de fonctionnement permettant d'obtenir des zones avec un oxyde fin dont l'épaisseur soit homogène sur toute la plaque de silicium ou même simplement en divers points de la plaque de silicium.

En outre, cette étape de polissage mécano chimique est également critique lorsqu'elle est effectuée en même temps sur deux matériaux différents, par exemple le silicium et l'oxyde de silicium comme dans le cas du substrat de la figure 3B ou de la figure 4B pour aboutir à la structure de la figure 3C ou respectivement 4C.

En effet, comme illustré sur la figure 5B, il est alors délicat d'éviter un polissage différentiel (« dishing » en terminologie anglaise) entre les zones 633 présentant en surface un semi-conducteur et les zones 634a, 634b présentant de l'oxyde en surface : le niveau de ces différentes zones n'est pas uniforme. Sur la figure 5B, les zones d'oxyde sont « en creux » par rapport aux zones de matériau semi-conducteur. Dans le cas où le semi-conducteur est le silicium et l'oxyde du SiO₂, on obtiendra au contraire des « creux » au niveau du silicium car le polissage mécano-chimique est plus efficace sur Si que sur SiO₂.

Dans les deux cas il en résulte une surface pouvant poser problème vis-à-vis d'un éventuel collage moléculaire.

Les problèmes exposés ci-dessus dans le cas d'un système silicium/oxyde de silicium SiO₂ se posent également avec d'autres matériaux semi-conducteurs et d'autres matériaux isolants.

Il se pose donc le problème de réaliser de telles plaques de matériau semi-conducteur présentant une surface structurée, donc présentant soit des épaisseurs variables d'isolant comme sur la figure 1A, soit des alternances matériau isolant et de semi-conducteur, comme sur la figure 2A, et compatibles avec un collage par adhésion moléculaire ultérieur.

On cherche notamment à ce que l'homogénéité en épaisseur des films isolants dans les zones isolantes fin soit bonne.

On cherche également à ce qu'un minimum de topologie soit présent en surface (et donc un minimum de « dishing » ou de différence de niveaux entre les zones d'isolant et les zones de semi-conducteur, comme expliqué ci-dessus), en particulier lorsqu'il y a alternance, à la surface, de semi-conducteur vierge et d'isolant.

Il se pose le problème de réaliser de telles structures sans avoir recours à une étape longue de polissage mécano-chimique qui pose les problèmes exposés ci-dessus en liaison avec les figures 5A et 5B.

### EXPOSÉ DE L'INVENTION

L'invention concerne un procédé de réalisation d'une structure semi-conductrice, sur un substrat semi-conducteur présentant en surface des motifs de profondeur p ce procédé comportant :
a) - une étape de formation d'une première couche en un premier matériau isolant sur ladite surface,
b) - une étape de formation d'une deuxième couche en un deuxième matériau isolant, moins dense que le premier matériau isolant, cette deuxième couche ayant une épaisseur inférieure à 3,5 fois la profondeur p,
c) - une étape d'amincissement de l'ensemble.

Selon l'invention, on utilise par-dessus la première couche d'isolant une deuxième couche, moins dense et d'une épaisseur limitée, permettant ainsi de limiter fortement les inhomogénéités qui apparaissent lors d'un polissage classique, d'une épaisseur d'isolant plus importante.

La topologie, ou encore le relief, en surface de la structure semi-conductrice, peut avoir une profondeur caractéristique p, et la couche en deuxième matériau isolant avoir une épaisseur comprise par exemple entre 2 p et 2,5 p.

La topologie peut être formée par des motifs gravés dans le substrat, séparés par des tranchées.

Ces motifs gravés ont par exemple une profondeur comprise entre 1 nm et 10 µm et/ou une largeur comprise entre 1 µm et 5 mm.

Le substrat peut être un substrat composite, par exemple du type comportant un film isolant en surface.

Selon un mode de réalisation, la première couche d'isolant est une couche conforme à la topologie du substrat.

L'étape c) peut laisser une couche de premier isolant sur la surface.

En outre une étape supplémentaire d'amincissement peut être prévue, laissant une alternance de zones semi-conductrices et de zones isolantes sur la surface.

Avant aplanissement, une étape de densification du deuxième matériau isolant peut être prévue.

La première couche d'isolant est de préférence une couche conforme à la topologie du substrat.

Le premier matériau isolant peut être de l'oxyde SiO₂ thermique, et le deuxième matériau isolant de l'oxyde SiO₂ déposé, par exemple par dépôt en phase vapeur par plasma.

Selon d'autres exemples, le matériau isolant est en Al₂O₃, ou en AlN, ou en SiON, ou en Si₃N₄, ou en diamant, ou en HfO₂, ou en un matériau diélectrique à forte constante diélectrique.

Le matériau semi-conducteur peut être en silicium ou en Si_{1-X}Geₓ (0<x<1) ou en un autre matériau semi-conducteur.

L'invention concerne également un procédé de réalisation d'une structure semi-conductrice, sur un substrat semi-conducteur présentant des plots en un premier matériau isolant dépassant d'une hauteur h par rapport à la surface du substrat ce procédé comportant :
a) - une étape de formation, sur le substrat et les plots, d'une couche en un deuxième matériau isolant, moins dense que le premier matériau isolant, cette couche ayant une épaisseur inférieure à 3,5 fois la hauteur h,
b) - une étape d'amincissement de l'ensemble.

Les différents matériaux (isolants, semiconducteurs) peuvent être ceux déjà indiqués ci-dessus.

Les plots peuvent être formés dans des zones gravées du substrat semi-conducteur.

Ils peuvent être formés par oxydation thermique du substrat semi-conducteur.

Ils peuvent aussi être formés par LPCVD, et la couche en deuxième matériau isolant en PECVD.

L'étape b) peut laisser subsister une couche de deuxième matériau isolant en surface, ou bien une alternance de zones en deuxième matériau isolant et de zones en premier matériau isolant.

Un procédé selon l'invention peut être réitéré, pour former des zones isolantes de différentes caractéristiques géométriques et/ou de compositions différentes. Par exemple, des masques différents d'une étape à l'autre permettent de définir des motifs ou une topologie différente d'une étape à l'autre.

Une étape d'assemblage avec un deuxième substrat peut être prévue, par exemple par adhérence moléculaire.

Le deuxième substrat peut être lui aussi en un deuxième matériau semi-conducteur, avec éventuellement en outre une couche d'isolant superficielle.

Le premier substrat peut avoir au moins une zone d'un premier type de conductivité, et le deuxième substrat une zone du type de conductivité opposée.

Une étape d'amincissement du premier et/ou du deuxième substrat peut en outre être réalisée, par exemple par formation d'une couche ou d'une zone de fragilisation.

Une couche ou zone de fragilisation peut être réalisée par une couche de silicium ou de semi-conducteur poreux, ou par implantation d'ions dans le premier ou le second substrat, par exemple des ions hydrogène ou un mélange d'ions hydrogène et d'ions hélium.

L'étape d'amincissement peut aussi être obtenue par polissage ou gravure.

Le premier substrat peut comporter des zones avec des dopages différents, par exemple des zones d'un premier type de conductivité dans certaines zones et des zones d'un deuxième type de conductivité dans d'autres zones.

### BRÈVE DESCRIPTION DES DESSINS

- Les figures 1A - 5B représentent des techniques connues et les problèmes posés par ces techniques,
- les figures 6A - 6E représentent des étapes d'un procédé selon l'invention,

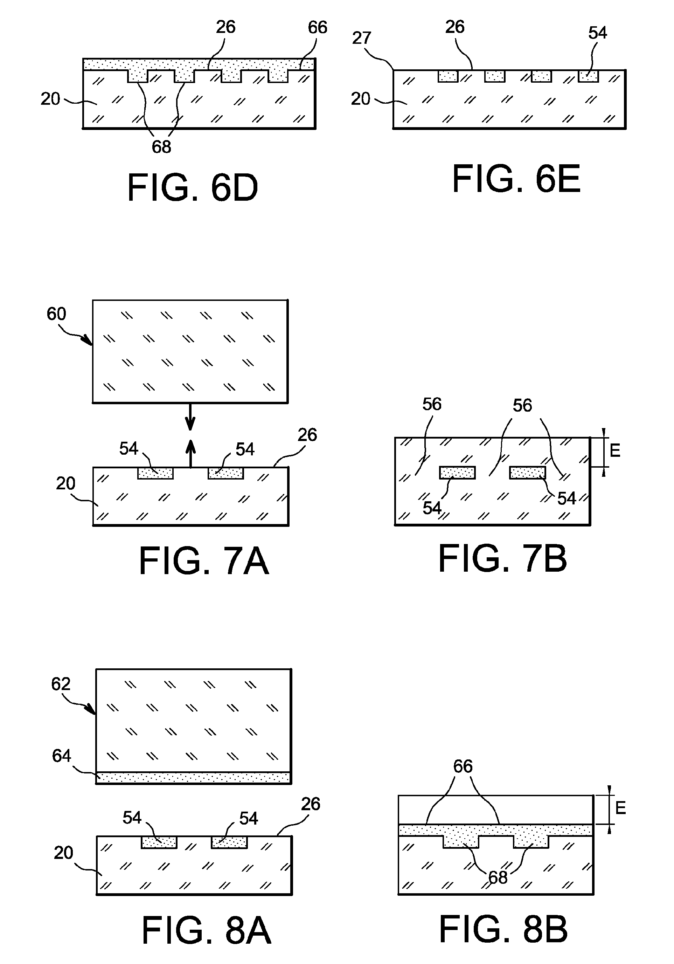

- les figures 7A - 7B représentent d'autres étapes d'un autre procédé selon l'invention,
- les figures 8A et 8B représentent encore d'autres étapes d'un autre procédé selon l'invention,

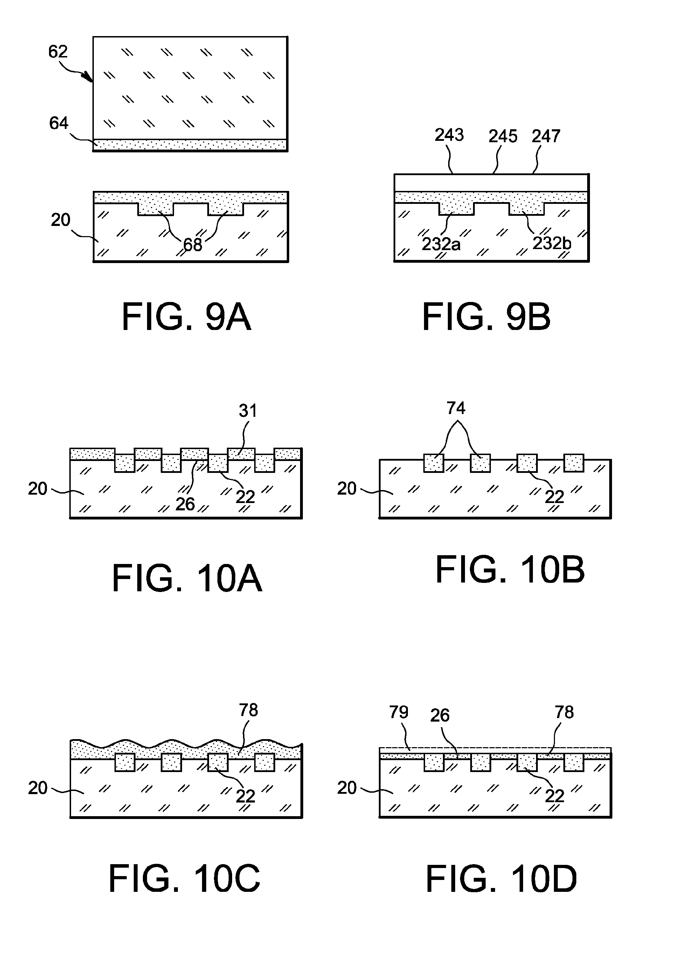

- les figures 9A et 9B représentent encore d'autres étapes d'un autre procédé selon la présente invention,
- les figures 10A - 13B représentent encore d'autres étapes d'autres procédés selon la présente invention.

### EXPOSÉ DÉTAILLÉ DE MODES DE RÉALISATION PARTICULIERS

Un exemple de réalisation de l'invention va être donné en liaison avec les figures 6A - 6E.

Dans une première étape, (figure 6A) on réalise sur un substrat 20 en un premier matériau semi-conducteur (par exemple du silicium) dans lequel une topologie ou des motifs 22 de profondeur p ont été gravés, un dépôt ou une formation 24 conforme d'un premier isolant, par exemple de l'oxyde thermique SiO₂.

Cet isolant recouvre tant les tranchées 22 formées dans le substrat par les zones gravées que les zones 26 situées entre ces tranchées, appelées travées. Le dépôt étant conforme, les motifs du substrat se retrouvent en surface supérieure de la couche 24.

Les motifs 22 ont par exemple été réalisés par photolithographie d'une résine à la surface de la plaque 20, puis gravure, par exemple gravure ionique réactive RIE. On supprime ensuite la résine sur la surface de la plaque de semi-conducteur.

De préférence, le premier isolant est déposé de sorte que la surface supérieure 29 de l'oxyde, dans les motifs gravés ou au-dessus de ces motifs, soit au moins à la hauteur de l'interface 27, dans les zones de travées 26, entre le matériau semi-conducteur et l'isolant.

Dans le cas de l'oxyde thermique, celui-ci est très conformant, et reproduit donc le relief de la surface de silicium. On peut considérer que la hauteur d'oxyde généré est environ au moins deux fois plus importante que la hauteur de silicium soumis à l'oxydation.

L'oxyde thermique 24 permet quant à lui d'assurer de bonnes propriétés électriques d'interface avec le matériau semi-conducteur sous jacent (notamment de faibles densités d'états d'interface à énergie faible).

Puis (figure 6B), un deuxième type 28 d'isolant, par exemple également du SiO₂, est déposé sur la première couche d'isolant. Ce deuxième type d'isolant est moins dense que le premier. Il peut s'agir d'un oxyde SiO₂ déposé, par exemple par dépôt en phase vapeur assisté par plasma PECVD. A sa surface sont présents des motifs qui, sans reproduire exactement la topologie initiale, rappellent néanmoins celle - ci.

Ce deuxième oxyde déposé permet de réduire l'épaisseur totale, dont on aurait besoin si on avait voulu aplanir les motifs par polissage mécano chimique.

Cette épaisseur se réduit à environ 3 fois la profondeur p du motif. Autrement dit, on dépose de préférence le deuxième isolant ou oxyde pour obtenir une épaisseur e inférieure à 3,5 fois la profondeur p ou comprise entre 2 fois ou 2,5 fois et 3,5 fois la profondeur p. Ce rapport n'est pas satisfait sur la figure 6B qui n'est pas à l'échelle.

L'épaisseur totale formée sur le substrat est donc réduite par rapport à l'utilisation du seul isolant 24. Par exemple, dans le cas d'isolant oxyde SiO2 thermique, l'utilisation de ce dernier nécessiterait une épaisseur d'environ 9 fois la profondeur p du motif pour pouvoir aplanir la topologie lors d'une étape de planarisation ultérieure, mais les inhomogénéités en épaisseur provoquées lors de l'étape d'aplanissement sont proportionnelles à l'épaisseur enlevée lors du polissage, et sont donc environ 3 fois plus importantes que lorsqu'un procédé selon l'invention est utilisé.

On peut ensuite (figure 6C) procéder à un aplanissement.

Il est d'abord possible de réaliser un aplanissement de la topologie dans l'isolant 28, laissant subsister une fine couche 19 (entraits interrompus sur la figure 6C) au - dessus de la zone dite « mixte », dans laquelle sont juxtaposés les deux types d'isolant.

Selon une variante, l'aplanissement est réalisé jusque dans cette zone mixte : c'est la situation représentée en traits pleins sur la figure 6C. La surface est alors une alternance de zones 50 provenant de la couche 28 d'oxyde déposé et de zones 52 de l'oxyde thermique 24.

Le polissage peut être effectué par polissage mécano-chimique.

On obtient alors une surface lissée, à une hauteur h au-dessus de l'interface de l'oxyde thermique et du matériau semi-conducteur, à l'aplomb des travées 26.

Un amincissement supplémentaire (figure 6D) est effectué par exemple par un polissage mécano chimique ou par une attaque chimique, telle qu'une attaque par solution d'acide fluorhydrique dilué par exemple à 1% ou à 10%, ou par une gravure ionique en plasma, telle que par exemple une gravure ionique réactive.

En vue de cette étape d'amincissement supplémentaire, une étape préalable de densification peut avoir été réalisée, lorsque la différence de vitesse d'amincissement, pour la technique d'amincissement utilisée, entre les deux types d'isolant ou d'oxydes (oxyde thermique et oxyde déposé), est importante, ce qui est la cas lorsque l'amincissement provoque un « dishing » supérieur à quelques nanomètres (on souhaite conserve la compatibilité avec un collage par adhérence moléculaire ultérieur). Mais, dans certains cas, par exemple de gravure ionique réactive sous plasma, cette différence se réduit et une densification n'a alors pas d'effet sensible.

Cette éventuelle étape de densification de l'oxyde déposé permet de lui conférer une densité proche de celle de l'oxyde thermique.

Si l'amincissement s'arrête au-dessus du niveau 27, on obtient une alternance de zones 68 d'isolant épais et de zones 66 d'isolant mince (figure 6D).

Selon une variante (figure 6E), l'amincissement supplémentaire, à partir de la configuration de la figure 6C, est réalisé jusqu'à atteindre l'interface 27 silicium - oxyde thermique au niveau des travées 26.

La surface de la plaque est alors plane constituée par une alternance de zones 26 de silicium et de zones 54 d'oxyde thermique.

La plaque ainsi structurée peut être nettoyée en vue d'un collage par adhésion moléculaire.

Par nettoyage, on entend ici, et plus généralement dans tout ce document, toute préparation de surface visant à obtenir des surfaces tout ou parties hydrophiles ou hydrophobes, cette préparation pouvant inclure des traitements thermiques, et/ou des traitements chimiques humide ou en voie sèche ou sous plasma, voire par affleurement de CMP (polissage mécano-chimique visant à atténuer la microrugosité de surface, de moins de 20 nm ou 30 nm, sans risque de causer du « dishing »).

La plaque ainsi obtenue peut alors être collée, par exemple sur une deuxième plaque 60 (figure 7A), ayant éventuellement subi un traitement de surface tel que celui indiqué ci-dessus en vue d'une adhésion moléculaire. Cette deuxième plaque peut être une plaque de semi-conducteur vierge, par exemple en silicium, également nettoyée en vue du collage moléculaire, de façon à former une structure baptisée « silicium sur isolant partiel » (PSOI en anglais).

Pour augmenter l'adhérence des plaques, la structure empilée est par exemple soumise à un traitement thermique. En outre, si le traitement thermique est effectué à haute température (par exemple supérieur ou égal à 1100°C), on peut provoquer la disparition à l'interface de collage d'un éventuel oxyde résiduel extrêmement fin, dans les zones correspondant aux travées 26. En vue de faciliter la disparition de cet oxyde éventuel d'interface on essayera autant que possible de minimiser le désalignement cristallographique entre les deux plaques assemblées.

Une des plaques peut être amincie de façon à obtenir l'épaisseur E souhaitée de film superficiel de semi-conducteur (figure 7B). Cette structure permet de disposer en alternance de zones 56 à conduction verticale et de zones 54 SOI.

Selon une variante, et afin d'obtenir un deuxième type de structure empilée (figure 8B), l'amincissement supplémentaire est, là encore, réalisé jusqu'à atteindre l'interface silicium oxyde thermique au niveau des travées.

La surface de la première plaque est alors encore plane et constituée par une alternance de zones de silicium et de zones d'oxyde thermique (figure 6E).

La première plaque de silicium est collée sur une deuxième plaque 62 (figure 8A), comportant en surface une couche d'isolant, par exemple en silicium oxydé (couche d'oxyde 64 en surface), et également nettoyée en vue du collage moléculaire, de façon à former une structure baptisée « silicium sur isolant multiple » (MSOI en anglais). Dans cette dernière approche, le film 64 d'oxyde de la deuxième plaque 62 sera avantageusement d'épaisseur fine, par exemple comprise entre 1 nm et 50 nm. Pour augmenter l'adhérence des plaques, la structure empilée est par exemple soumise à un traitement thermique.

Une des plaques peut être amincie de façon à obtenir l'épaisseur de film superficiel de silicium voulu (figure 8B). Cette structure permet de disposer, dans le cas du silicium et du SiO₂, en alternance, de zones SOI 66, 68 à épaisseur d'oxyde variable.

Selon encore un autre variante, et afin d'obtenir une structure empilée du type de la figure 8B, l'amincissement supplémentaire est réalisé de façon à laisser un film fin d'oxyde thermique au-dessus des travées (figure 6D).

La surface de la plaque est alors plane constituée par une alternance de zones 66 d'oxyde thermique fin et de zones 68 d'oxyde thermique plus épais. La première plaque de silicium ainsi structurée peut être nettoyée en vue d'un collage par adhésion moléculaire.

Cette première plaque de silicium peut alors être collée par exemple sur une deuxième plaque telle que la plaque 60 (figure 7A), par exemple une plaque de silicium vierge également nettoyée en vue du collage moléculaire, de façon à former une structure baptisée « silicium sur isolant multiple » (MSOI en anglais) telle que celle de la figure 8B.

Pour augmenter l'adhérence des plaques, la structure empilée est par exemple soumise à un traitement thermique. Une des plaques peut être amincie de façon à obtenir l'épaisseur de film superficiel de silicium voulu. Cette structure permet de disposer en alternance de zones à conduction verticales et de zones SOI, comme sur la figure 8B.

Une variante de ce procédé peut toutefois permettre la réalisation d'une structure de type PSOI (du type de la figure 7B).

En effet, avant le collage, la plaque de la figure 6D est constituée de zones d'oxyde thermique mince et de zones d'oxyde thermique épais avec une surface plane.

Il est donc possible d'attaquer de façon globale cette surface afin de déboucher sur le silicium, au niveau des travées 26, après avoir enlevé une épaisseur d'oxyde de silicium correspondant à l'épaisseur des zones d'oxyde thermique mince. Cette attaque d'oxyde peut se faire de différentes manières : par une solution chimique, par un plasma, par un bombardement ionique...

On choisit de préférence un type d'attaque dont la différence de vitesse d'attaque du silicium et de l'oxyde soit la plus faible possible, de façon à éviter de provoquer un « dishing », lié à la présence en surface à la fois du silicium et de l'oxyde thermique. On choisit de préférence une faible sélectivité (rapport des vitesses d'attaque) inférieure à 5. Une solution à base de HF diluée, par exemple à 1%, est possible, mais l'arrêt de l'attaque est alors délicat à maîtriser. En revanche une solution à base de NH₄OH/H₂O₂/H₂O, présente un rapport de vitesse d'attaque seulement d'environ 2, ce qui est plus aisé à utiliser. De la même façon, une attaque par bombardement ionique présente une différence faible de vitesse d'attaque.

Selon encore un autre variante, et afin d'obtenir une structure empilée du type de la figure 8B, l'amincissement supplémentaire est réalisé de façon à laisser un film fin d'oxyde thermique au-dessus des travées (figure 6D). La surface de la plaque est alors plane, constituée, par une alternance de zones 66 d'oxyde thermique fin et de zones 68 d'oxyde thermique plus épais.

Cette première plaque est collée sur une deuxième plaque 62 (figure 9A), par exemple une deuxième plaque de silicium oxydée (couche d'oxyde 64) et également nettoyée en vue du collage moléculaire, de façon à former une structure baptisée « silicium sur isolant multiple » (MSOI en anglais), comme sur la figure 8B.

Dans cette approche, le film d'oxyde de la deuxième plaque sera avantageusement d'épaisseur fine, par exemple compris entre 1 nm et 50 nm.

Pour augmenter l'adhérence des plaques, la structure empilée peut être par exemple soumise à un traitement thermique.

Une des plaques peut en outre être amincie de façon à obtenir l'épaisseur voulue de film superficiel. Cette structure permet de disposer en alternance de zones SOI 66, 68 à épaisseur d'oxyde variable (figure 9B).

Une partie de l'épaisseur d'une des deux plaques collées peut être réduite, dans une des étapes du procédé, afin d'obtenir la bonne épaisseur du film superficiel de silicium et de réaliser les structures MSOI ou PSOI souhaitées.

Cette réduction peut se faire par exemple par l'une des techniques suivantes :
- Amincissement mécanique, par exemple de type meulage (« grinding » en anglais),
- Polissage mécano-chimique,
- Implantation préalable au collage moléculaire d'espèces gazeuses dans la plaque à amincir et fracture telle qu'utilisée dans la technologie SmartCut TM,
- Amincissement par gravure ionique et/ou chimique,
- Inclusion préalable au collage d'une zone de fragilisation enfouie dans la plaque à amincir (telle qu'une zone poreuse ou une zone d'implantation ionique, par exemple d'implantation d'ions hydrogène et éventuellement hélium),
ou toute combinaison d'au moins deux de ces techniques.

D'autres variantes des procédés décrits ci-dessus peuvent être réalisées.

Par exemple la plaque 20 de départ peut être dopée, éventuellement avec des dopages divers dans les différentes zones. Par exemple il peut y avoir un dopage P+ au niveau des zones à conduction verticale, là où ne se trouve aucune zone isolante, tandis que les autres zones ont un dopage différent ou pas de dopage.

De même, lors de l'assemblage avec une deuxième plaque (figures 7A et 7B), l'une des plaques peut être d'un type de dopage (par exemple Si type N) et l'autre d'un autre type (par exemple Si type P).

De même, l'exemple du silicium a été donné ci-dessus, mais un procédé selon l'invention peut être appliqué à d'autres semi-conducteurs que le silicium, pour la première plaque et/ou pour la seconde plaque. On citera par exemple Si₁₋ₓGeₓ avec 0≤x≤1 ou encore un substrat multicouche III - V.

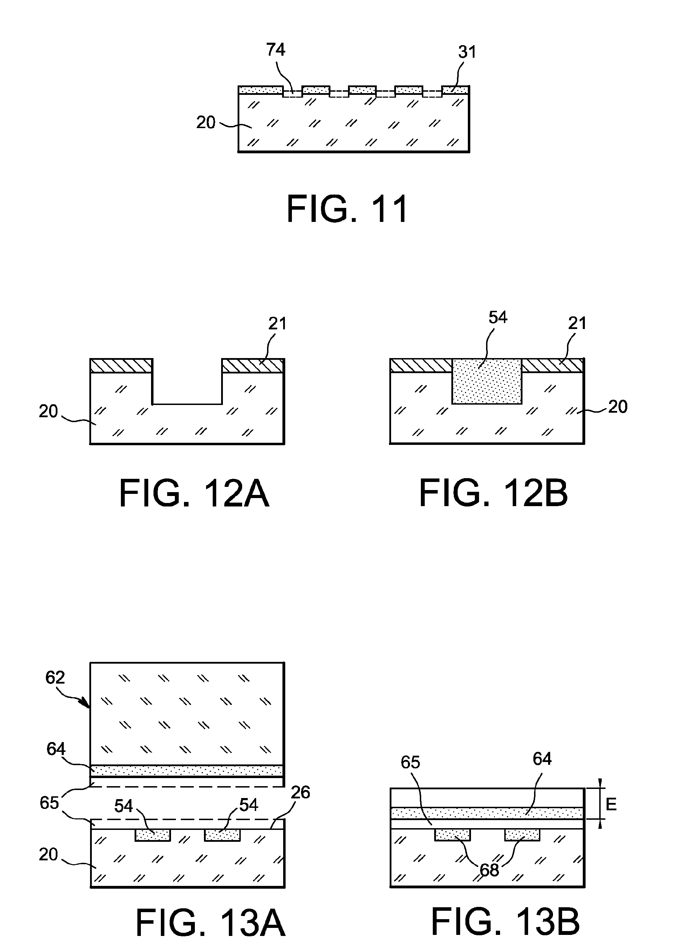

Comme illustré sur le figure 12A, le substrat peut aussi être un substrat composite, pouvant comprendre à sa surface un film 21 d'isolant, par exemple en AlN. Cette structure peut ensuite être recouverte par exemple par un dépôt de type LPCVD considéré comme premier oxyde 24 (figure 6A) et sur lequel un deuxième isolant, moins dense, sera rajouté pour effectuer un lissage de la topologie comme déjà expliqué ci-dessus. Au final, on pourra obtenir une structure telle que celle de la figure 12B, comportant une alternance d'isolants 21, 54, pouvant présenter des propriétés thermiques et/ou électriques différentes. Par exemple, l'isolant 21 est un isolant électrique, tandis que l'isolant 54 est un isolant à la fois du point de vue électrique et thermique.

Sur la deuxième plaque 62 (figures 8A, 9A) l'épaisseur du film isolant (par exemple en oxyde fin) 64 pourra être dans la gamme de 1 nm à quelques micromètres, par exemple 10 µm.

La profondeur p des motifs gravés 62 peut être de quelques nanomètres à quelques micromètres, par exemple comprise entre 1 nm ou 5 nm et 1 µm ou 3 µm.

La dimension latérale L des motifs peut être typiquement dans la gamme de 0,1 µm à quelques millimètres, par exemple 5 mm.

L'épaisseur E des films superficiels de silicium dans les structures finales (figures 7B, 8B) peut être par exemple dans la gamme de quelques nanomètres à quelques dizaines de microns, par exemple comprise entre 1 nm et 50 µm.

Dans la réalisation des structures de type MSOI (figure 8B) l'isolant fin peut aussi être élaboré (par dépôt, ou par croissance...) sur une au moins des deux plaques à coller après l'étape de préparation de la surface structurée.

Le procédé peut être adapté avec d'autres isolants que l'oxyde de silicium SiO₂, en tant que film fin d'isolant élaboré ou formé sur la première et/ou la deuxième plaque et/ou en tant que film fin d'isolant 65 élaboré, dans une étape supplémentaire, sur une plaque structurée et/ou sur une deuxième plaque 62 d'assemblage telle que représentée en figure 13A. La figure 13B représente les deux éléments de la figure 13A après assemblage, un film 65 d'isolant séparant les zones 68 et la couche 64.

On peut citer par exemple, en tant qu'isolant, Al2O3, ou AlN, ou SiON, ou Si3N4, ou le diamant, ou HfO2, ou tout diélectrique à fort coefficient K, etc. ou toute combinaison de ces matériaux.

Si il est réitéré, un procédé selon l'invention permet de réaliser des épaisseurs p différentes et/ou deux largeurs L différentes d'isolant 54 (cas de la figure 6E) dans un même substrat, alternant avec des zones semi-conductrices.

On peut également réaliser des zones 54 en un premier type d'isolant puis des zones d'un autre type d'isolant.

On peut donc réaliser un substrat semi-conducteur avec des zones isolantes qui peuvent être différentes par leurs dimensions géométriques (profondeur et/ou largeur) et/ou par les natures des matériaux qui les constituent.

Ces différentes zones isolantes sont obtenues par réitération d'un procédé selon l'invention, avec des masques différents lors des différentes étapes de formation des différentes zones isolantes.

Un procédé selon l'invention peut donc être réitéré plusieurs fois sur la même première plaque. Dans le procédé et les divers exemples de réalisation, des étapes de renforcement du collage moléculaire (nettoyages spécifiques des surfaces, activation des surfaces par plasma, collage sous atmosphère spécifique, traitements thermiques...) peuvent être appliquées.

Il est également possible de réaliser un polissage fin de type mécano-chimique (« touch polishing » en anglais) afin d'améliorer la micro-rugosité des surfaces d'oxyde. Ce traitement est considéré comme un traitement de surface (très faible enlèvement de matière) par opposition au procédé de polissage permettant d'aplanir, à grande échelle, une topographie des surfaces d'oxyde.

Selon un autre exemple de réalisation illustré en figures 10 A-10C, les travées 26 d'un substrat 20 en matériau semi-conducteur, par exemple en silicium, dans lequel des motifs 22 de profondeur p ont été gravés, sont recouvertes d'un masque 31.

Un premier isolant est formé, par exemple par technique LPCVD ou par oxydation thermique (notamment dans le cas où le substrat est en silicium).

Le masque 31 est ensuite retiré (figure 10B), laissant subsister des plots d'isolant, ces plots définissant une topologie de surface du substrat 20.

Il est ensuite possible (figure 10C) de réaliser un dépôt d'un deuxième isolant 78, par exemple par dépôt PECVD, moins dense que le matériau des plots 74.

Si les plots 74 dépassent d'une hauteur h au dessus du substrat, un dépôt d'une couche d'épaisseur inférieure à 3,5 h permettra d'aplanir la topologie de surface.

Ce deuxième isolant 78 déposé permet d'éviter le phénomène de « dishing » qu'on aurait eu si on avait voulu lisser les motifs 74 par polissage mécano chimique.

Le deuxième isolant permet d'aplanir la topologie en amincissant un film d'une seule nature de matériau alors qu'un procédé direct aurait deux matériaux en surface.

On peut ensuite (figure 10D) procéder à un aplanissement soit en laissant subsister une fine couche 79 au - dessus de la zone dite « mixte » (voir couche en traits interrompus sur la figure 10D), dans laquelle sont juxtaposés les deux types d'isolant 74, 78, soit jusque dans cette zone mixte : c'est la situation représentée en traits pleins sur la figure 10D. La surface est alors une alternance de zones provenant de la couche 78 d'isolant et de zones 74 de l'isolant formé initialement sous forme de plots. Ces différentes zones peuvent présenter des propriétés différentes, par exemple du point de vue thermique et/ou du point de vue électrique.

Un polissage peut être effectué par polissage mécano-chimique.

Dans le cas où le premier isolant est obtenu par oxydation thermique, le substrat 20 n'a pas nécessairement besoin de comporter des tranchées 22.

Ce mode de réalisation est illustré en figure 11, où la référence 31 désigne un masque, par exemple en nitrure Si3N4, sur un substrat 20 non préalablement gravé. Une oxydation thermique permet de faire croître, à travers le masque 31, des plots 74 d'oxyde thermique (indiqués en traits interrompus sur la figure 11). Lors d'une oxydation thermique, les atomes d'oxygène pénètrent dans la maille du silicium, ce qui provoque un gonflement de cette dernière. Grâce à ce gonflement, la surface de l'oxyde en formation se rapproche de la surface du nitrure du masque 31.

On peut considérer que la hauteur d'oxyde généré est environ deux fois plus importante que la hauteur de silicium soumis à l'oxydation.

La vitesse de formation de l'oxyde peut être contrôlée, à une vitesse comprise entre 1 nm/mn et 10 nm/mn.

Le masque est ensuite enlevé, et on retrouve la structure de la figure 10B, qui peut donner lieu aux étapes décrites ci-dessus en liaison avec les figures 10C et 10D.

Les composants obtenus selon les procédés décrits en liaison avec les figures 10A-13B peuvent être assemblés avec un deuxième substrat, comme indiqué ci-dessus en liaison avec les figures 7A, 8A, 9A.

D'autres exemples de réalisation vont être maintenant donnés.

### Premier exemple

Dans ce premier exemple, les motifs sont gravés avec un procédé de type RIE (reactive ion etching) et ont une profondeur de 50 nanomètres dans le silicium.

L'oxyde SiO₂ est généré dans ces motifs et à l'aplomb des travées par un traitement thermique à 900°C sous atmosphère de vapeur d'eau. Son épaisseur est de 120 nanomètres (figure 6A).

Un film de SiO₂ de 150 nm est déposé par PECVD à la surface du film d'oxyde thermique (figure 6B). Un polissage par CMP permet de supprimer la topologie (relief de surface). La surface est alors lisse et le film d'oxyde déposé est poli jusqu'à la cote où émerge l'oxyde thermique, début de la zone dite d'oxyde mixte (figure 6C).

Une densification de l'oxyde déposé est réalisée à 900°C sous atmosphère d'oxygène pendant 1h.

Un amincissement complémentaire est effectué par exemple par CMP ou par attaque HF (HF dilué à 10% voire 1%) ou par gravure ionique réactive, en plasma CHF3 par exemple. L'amincissement complémentaire n'entraîne pas ou peu de « dishing » entre les zones d'oxydes différents (oxyde thermique et oxyde déposé densifié). L'amincissement complémentaire est poursuivi après le retrait de la zone mixte d'oxyde et est tel qu'une épaisseur d'oxyde thermique de 10 nm est laissée en surface des zones travées (figure 6D)

La première plaque ainsi structurée est plane, lisse, compatible avec un collage moléculaire ultérieur. A sa surface on obtient une alternance de zones 66 d'oxyde thermique fin et de zones d'oxyde thermique épais (figure 6D). La plaque est alors nettoyée de façon à supprimer les éventuels hydrocarbures, à retirer les particules, à rendre la surface hydrophile.

Cette première plaque structurée est alors collée sur une deuxième plaque de silicium oxydé (épaisseur du film d'oxyde 10 nanomètres) nettoyée suivant la même procédure (figure 9A). La structure empilée est soumise à un traitement thermique à 1100°C pendant 2h sous atmosphère d'argon.

La seconde plaque de silicium de cette structure empilée est ensuite amincie par une technique de meulage pour ne laisser, par exemple, que 25 micromètres de silicium. On obtient de cette façon une structure empilée de type MSOI (figure 9B).

### Deuxième exemple

Dans ce deuxième exemple, les motifs sont gravés avec un procédé de type RIE (reactive ion etching) et ont une profondeur de 50 nanomètres dans le silicium. L'oxyde est généré dans ces motifs et à l'aplomb des travées par un traitement thermique à 900°C sous atmosphère de vapeur d'eau. Son épaisseur est de 120 nanomètres (figure 6A).

Un film de SiO₂ de 150 nm est déposé par PECVD à la surface du film d'oxyde thermique. Un polissage par CMP permet de supprimer la topologie (relief de surface). La surface est lisse et le film d'oxyde déposé est poli jusqu'à la côte où émerge l'oxyde thermique, début de la zone dite d'oxyde mixte (figure 6C).

Une densification de l'oxyde déposé est réalisée à 900°C sous atmosphère d'oxygène pendant 1h.

Un amincissement complémentaire est effectué par exemple par CMP ou par attaque HF (HF dilué à 10% voire 1%) ou par gravure ionique réactive, en plasma CHF3 par exemple. L'amincissement complémentaire n'entraîne pas ou peu de dishing entre les zones d'oxydes différents (oxyde thermique et oxyde déposé densifié). L'amincissement complémentaire est poursuivi après le retrait de la zone mixte d'oxyde et est tel qu'une épaisseur d'oxyde thermique de 10 nm est laissée en surface des zones travées (figure 6D).

La première plaque structurée est plane, lisse, compatible avec un collage moléculaire ultérieur. A sa surface on obtient une alternance de zones d'oxyde thermique fin et de zones 68 d'oxyde thermique épais. La plaque est alors nettoyée de façon à supprimer les éventuels hydrocarbures, à retirer les particules, à rendre la surface hydrophile.

Cette première plaque structurée est alors collée sur une deuxième plaque de silicium non oxydé nettoyée suivant la même procédure. La structure empilée est soumise à un traitement thermique à 1100°C pendant 2h sous atmosphère d'argon. La seconde plaque de silicium de cette structure empilée est alors amincie par une technique de meulage pour ne laisser, par exemple, que 25 micromètres de silicium. On obtient de cette façon une structure empilée de type MSOI.

### Troisième exemple

Dans ce troisième exemple, les motifs sont gravés avec un procédé de type RIE (reactive ion etching) et ont une profondeur de 50 nanomètres dans le silicium. L'oxyde est généré dans ces motifs et à l'aplomb des travées par un traitement thermique à 900°C sous atmosphère de vapeur d'eau. Son épaisseur est de 120 nanomètres (figure 6A).

Un film de SiO₂ de 150 nm est déposé par PECVD à la surface du film d'oxyde thermique. Un polissage par CMP permet de supprimer la topologie (relief de surface). La surface est lisse et le film d'oxyde déposé est poli jusqu'à la côte où émerge l'oxyde thermique, début de la zone dite d'oxyde mixte (figure 6C).

Une densification de l'oxyde déposé est réalisée à 900°C sous atmosphère d'oxygène pendant 1h.

Un amincissement complémentaire est effectué par exemple par CMP ou par attaque HF (HF dilué à 10% voire 1%) ou par gravure ionique réactive, en plasma CHF3 par exemple. L'amincissement complémentaire n'entraîne pas ou peu de dishing entre les zones d'oxydes différents (oxyde thermique et oxyde déposé densifié). L'amincissement complémentaire est poursuivi après le retrait de la zone mixte d'oxyde, et est tel qu'il débouche en surface silicium des zones travées(figure 6E).

La première plaque structurée est plane, lisse, compatible avec un collage moléculaire ultérieur et présente une alternance de zones de silicium et de zones d'oxyde thermique. La plaque est alors nettoyée de façon à supprimer les éventuels hydrocarbures, à retirer les particules, à rendre la surface hydrophile.

Cette première plaque structurée est alors collée sur une deuxième plaque de silicium oxydé (épaisseur du film d'oxyde 10 nanomètres) nettoyée suivant la même procédure (figure 8A). La structure empilée est soumise à un traitement thermique à 1100°C pendant 2 h sous atmosphère d'argon. La seconde plaque de silicium de cette structure empilée est alors amincie par une technique de meulage pour ne laisser, par exemple, que 25 micromètres de silicium (figure 8B). On obtient de cette façon une structure empilée de type MSOI.

Dans une variante de cet exemple, cette attaque finale d'oxyde thermique peut se faire de différentes manières (par exemple CMP, ou par Plasma ionique réactif, ou par attaque chimique).

On choisit un type d'attaque tel que la différence de vitesse d'attaque du silicium et de l'oxyde soit la plus faible possible, de façon à éviter de provoquer un « dishing », au moment où on débouche sur la surface de silicium des travées, « dishing » lié à la présence en surface à la fois du silicium et de l'oxyde thermique.

Une solution à base de HF diluée, par exemple à 1 %, est possible, mais l'arrêt de l'attaque est délicat à maîtriser.

Une solution à base de NH₄OH/H₂O₂/H₂O, présente un rapport de vitesse d'attaque seulement d'environ 2, ce qui semble plus aisé à maîtriser. De la même façon, une attaque par bombardement ionique présente une différence faible de vitesse d'attaque.

### Quatrième exemple

Dans ce quatrième exemple, les motifs sont gravés avec un procédé de type RIE (reactive ion etching) et ont une profondeur de 50 nanomètres dans le silicium. L'oxyde est généré dans ces motifs et à l'aplomb des travées par un traitement thermique à 900°C sous atmosphère de vapeur d'eau. Son épaisseur est de 120 nanomètres (figure 6A).

Un film de SiO₂ de 150 nm est déposé par PECVD à la surface du film d'oxyde thermique (figure 6B). Un polissage par CMP permet de supprimer la topologie (relief de surface). La surface est lisse et le film d'oxyde déposé est poli jusqu'à la cote où émerge l'oxyde thermique, début de la zone dite d'oxyde mixte (figure 6C).

Une densification de l'oxyde déposé est réalisée à 900°C sous atmosphère d'oxygène pendant 1h.

Un amincissement complémentaire est effectué par exemple par CMP ou par attaque HF (HF dilué à 10% voire 1%) ou par gravure ionique réactive, en plasma CHF3 par exemple. L'amincissement complémentaire n'entraîne pas ou peu de dishing entre les zones d'oxydes différents (oxyde thermique et oxyde déposé densifié). L'amincissement complémentaire est poursuivi après le retrait de la zone mixte d'oxyde et est tel qu'il débouche en surface silicium des zones travées (figure 6E).

La première plaque structurée est plane, lisse, compatible avec un collage moléculaire ultérieur et présente une alternance de zones de silicium et de zones d'oxyde thermique.

La plaque est alors nettoyée de façon à supprimer les éventuels hydrocarbures, à retirer les particules, à rendre la surface hydrophile. Cette première plaque structurée est alors collée sur une deuxième plaque de silicium non oxydé nettoyée suivant la même procédure (figure 7A). La structure empilée est soumise à un traitement thermique à 1100°C pendant 2h sous atmosphère d'argon.

En outre, si le traitement thermique est effectué à haute température (par exemple supérieur ou égal à 1100°C), on peut provoquer la disparition à l'interface de collage de l'oxyde extrêmement fin, dans les zones correspondant aux travées.

En vue de faciliter la disparition de l'éventuel oxyde d'interface on essaye, autant que possible, de minimiser le désalignement cristallographique entre les deux plaques de silicium collées. La seconde plaque de silicium de cette structure empilée est alors amincie par une technique de meulage pour ne laisser, par exemple, que 25 micromètres de silicium. On obtient de cette façon une structure empilée de type PSOI (figure 7B).

### Cinquième exemple

Dans ce cinquième exemple, les motifs sont gravés avec un procédé de type RIE (reactive ion etching) et ont une profondeur de 50 nanomètres dans le silicium. L'oxyde est généré dans ces motifs et à l'aplomb des travées par un traitement thermique à 900°C sous atmosphère de vapeur d'eau. Son épaisseur est de 120 nanomètres (figure 6A).

Un film de SiO₂ de 150 nm est déposé par PECVD à la surface du film d'oxyde thermique. Un polissage par CMP permet de supprimer la topologie (relief de surface). La surface est lisse et le film d'oxyde déposé est poli jusqu'à la côte où émerge l'oxyde thermique, début de la zone dite d'oxyde mixte (figure 6C).

Une densification de l'oxyde déposé est réalisée à 900°C sous atmosphère d'oxygène pendant 1h.

Un amincissement complémentaire est effectué par exemple par CMP ou par attaque HF (HF dilué à 10% voire 1%) ou par gravure ionique réactive, en plasma CHF3 par exemple. L'amincissement complémentaire n'entraîne pas ou peu de dishing entre les zones d'oxydes différents (oxyde thermique et oxyde déposé densifié). L'amincissement complémentaire est poursuivi après le retrait de la zone mixte d'oxyde et est tel qu'il débouche en surface silicium des zones travées (figure 6E).

La première plaque structurée est plane, lisse, compatible avec un collage moléculaire ultérieur et présente une alternance de zones 26 de silicium et de zones 54 d'oxyde thermique. La plaque est alors nettoyée de façon à supprimer les éventuels hydrocarbures, à retirer les particules, à rendre la surface hydrophile.

La deuxième plaque de silicium est oxydée sur une épaisseur de 20nm (figure 8A). Elle est alors soumise à une implantation par bombardement ionique d'hydrogène (energie 70KeV, dose 5 1016 at/cm2). La première plaque structurée est alors collée sur la deuxième plaque de silicium oxydé, implantée, nettoyée en vue du collage moléculaire.

La structure empilée est soumise par exemple à un traitement thermique à 500°C pendant 30mn sous atmosphère d'argon. Une fracture est alors induite dans la deuxième plaque de silicium. Après diverses étapes décrites dans la technologie SmartCutTM, on obtient un film de silicium superficiel de 50 nm d'épaisseur. On obtient de cette façon une structure empilée de type MSOI avec en particulier localement des zones d'oxyde et de silicium très fins (figure 8B).

### Sixième exemple

Dans ce sixième exemple, les motifs sont gravés avec un procédé de type RIE (reactive ion etching) et ont une profondeur de 100 nanomètres dans le silicium. L'oxyde est généré dans ces motifs et à l'aplomb des travées par un traitement thermique à 900°C sous atmosphère de vapeur d'eau). Son épaisseur est de 120 nanomètres. La topologie de surface a une hauteur de 100 nm (figure 6A).

Un film de SiO₂ de 300 nm est déposé par PECVD à la surface du film d'oxyde thermique. Un polissage par CMP permet de supprimer la topologie (relief de surface). La surface est lisse et le film d'oxyde déposé est poli jusqu'à la cote où émerge l'oxyde thermique, début de la zone dite d'oxyde mixte (figure 6C).

Une densification de l'oxyde déposé est réalisée à 900°C sous atmosphère d'oxygène pendant 1h.

Un amincissement complémentaire est effectué par exemple par CMP ou par attaque HF (HF dilué à 10% voire 1%) ou par gravure ionique réactive, en plasma CHF3 par exemple. L'amincissement complémentaire n'entraîne pas ou peu de dishing entre les zones d'oxydes différents (oxyde thermique et oxyde déposé densifié). L'amincissement complémentaire est poursuivi après le retrait de la zone mixte d'oxyde et est tel qu'il débouche en surface silicium des zones travées (figure 6E).

La première plaque structurée est plane, lisse, compatible avec un collage moléculaire ultérieur et présente une alternance de zones de silicium et de zones d'oxyde thermique. La plaque est alors nettoyée de façon à supprimer les éventuels hydrocarbures, à retirer les particules, à rendre la surface hydrophile. La deuxième plaque de silicium est oxydée sur une épaisseur de 20 nm.

Elle est alors soumise à une implantation par bombardement ionique d'hydrogène (energie 70KeV, dose 5 1016 at/cm2). La première plaque structurée est alors collée sur la deuxième plaque de silicium oxydée (figure 8A), implantée, nettoyée en vue du collage moléculaire. La structure empilée est soumise par exemple à un traitement thermique à 500°C pendant 30mn sous atmosphère d'argon. Une fracture est alors induite dans la deuxième plaque de silicium.

Après diverses étapes décrites dans la technologie SmartCutTM (voir par exemple l'article de Auberton Hervé et al. Cité dans l'introduction à la présente demande) on obtient un film de silicium superficiel de 50 nm d'épaisseur. On obtient de cette façon une structure empilée de type MSOI avec en particulier localement des zones d'oxyde et de silicium très fins (figure 8B).

## Revendications

1. Procédé de réalisation d'une structure semi-conductrice, sur un substrat semi-conducteur présentant en surface des motifs de profondeur p ce procédé comportant :
a) - une étape de formation d'une première couche (24) en un premier matériau isolant sur ladite surface,
b) - une étape de formation d'une deuxième couche, sur la première couche, en un deuxième matériau isolant (28), moins dense que le premier matériau isolant, cette deuxième couche ayant une épaisseur inférieure à 3,5 fois la profondeur p,
c) - une étape d'amincissement de l'ensemble.

2. Procédé selon la revendication 1, la topologie étant formée par des motifs (22) gravés dans le substrat, séparés par des travées (26).

3. Procédé selon la revendication 2, les motifs gravées (34) ayant une profondeur comprise entre 1 nm et 10 µm.

4. Procédé selon l'une des revendications 2 ou 3, les motifs gravées ayant une largeur comprise entre 1 µm et 5 mm.

5. Procédé selon l'une des revendications 1 à 4, le substrat étant un substrat composite.

6. Procédé selon la revendication 5, comportant un film isolant (21) en surface.

7. Procédé selon l'une des revendications 1 à 6, la première couche d'isolant (24) étant une couche conforme à la topologie du substrat.

8. Procédé selon l'une des revendications 1 à 7, l'étape c) laissant une couche de premier isolant (66) sur la surface.

9. Procédé selon la revendication 8, comportant en outre une étape supplémentaire d'amincissement, laissant une alternance de zones semi-conductrices (54) et de zones isolantes (26) sur la surface.

10. Procédé de réalisation d'une structure semi-conductrice, sur un substrat semi-conducteur présentant des plots (74) en un premier matériau isolant dépassant d'une hauteur h par rapport à la surface du substrat ce procédé comportant :
a) - une étape de formation, sur le substrat et les plots, d'une couche en un deuxième matériau isolant (78), moins dense que le premier matériau isolant, cette couche ayant une épaisseur inférieure à 3,5 fois la hauteur h,
b) - une étape d'amincissement de l'ensemble.

11. Procédé selon la revendication 10, les plots étant formés dans des zones gravées (22) du substrat semi-conducteur.

12. Procédé selon la revendication 10 ou 11, les plots étant formés par oxydation thermique du substrat semi-conducteur.

13. Procédé selon la revendication 10 ou 11, les plots étant formés par LPCVD, et la couche en deuxième matériau isolant en PECVD.

14. Procédé selon l'une des revendications 10 à 13, l'étape b) laissant subsister une couche (79) de deuxième matériau isolant en surface.

15. Procédé selon l'une des revendications 10 à 13, l'étape b) laissant subsister en surface une alternance de zones (78) en deuxième matériau isolant et de zones (22) en premier matériau isolant.

16. Procédé selon l'une des revendications 1 à 15, l'étape d'amincissement étant précédée d'une étape de densification du deuxième matériau isolant.

17. Procédé selon l'une des revendications 1 à 16, le premier matériau isolant étant de l'oxyde SiO₂ thermique.

18. Procédé selon l'une des revendications 1 à 17, le deuxième matériau isolant étant de l'oxyde SiO₂ déposé.

19. Procédé selon la revendication 18, l'oxyde étant déposé par dépôt en phase vapeur par plasma.

20. Procédé selon l'une des revendications 1 à 19, le matériau isolant étant en Al₂O₃, ou en AlN, ou en SiON, ou en Si₃N₄, ou en diamant, ou en HfO₂, ou en un matériau diélectrique à forte constante diélectrique.

21. Procédé selon l'une des revendications 1 à 20, le matériau semi-conducteur étant en silicium ou en Si_{1-X}Geₓ (0<x<1).

22. Procédé de réalisation d'une structure semi-conductrice comportant la formation :
a1) - d'une première zone isolante dans un substrat semi-conducteur,
b1) - puis la formation d'au moins une deuxième zone isolante dans le même substrat,
les étapes a1) et b1) étant effectuées selon l'une des revendications 1 à 21.

23. Procédé selon la revendication 22, les étapes a1) et b1) étant effectuées avec des masques différents.

24. Procédé selon la revendications 22 ou 23, au moins deux des zones isolantes formées ayant des profondeurs et/ou des largeurs différentes dans le substrat et/ou étant formées de matériaux isolants différents.

25. Procédé selon l'une des revendications 1 à 24, comportant en outre une étape d'assemblage avec un deuxième substrat (60, 62).

26. Procédé selon la revendication 25, l'assemblage étant réalisé par adhérence moléculaire.

27. Procédé selon la revendication 25 ou 26, le deuxième substrat étant en un deuxième matériau semi-conducteur.

28. Procédé selon la revendication 27, le deuxième substrat comportant en outre une couche (64) d'isolant sur le deuxième matériau semi-conducteur.

29. Procédé selon l'une des revendications 25 à 28, un film isolant (65) étant formé sur au moins un des deux substrats.

30. Procédé selon l'une des revendications 25 à 29, le premier substrat ayant au moins une zone d'un premier type de conductivité, et le deuxième substrat ayant au moins une zone du type de conductivité opposée.

31. Procédé selon l'une des revendications 25 à 30, comportant en outre une étape d'amincissement du premier et/ou du deuxième substrat.

32. Procédé selon la revendication 31, l'étape d'amincissement de l'un et/ou de l'autre des substrats étant réalisée par formation d'une couche ou d'une zone de fragilisation.

33. Procédé selon la revendication 32, la couche ou la zone de fragilisation étant réalisée par une couche de silicium poreux.

34. Procédé selon la revendication 32, la formation d'une couche ou d'une zone de fragilisation étant réalisée par implantation d'ions dans le premier ou le second substrat.

35. Procédé selon la revendication 34, les ions implantés étant des ions hydrogène ou un mélange d'ions hydrogène et d'ions hélium.

36. Procédé selon la revendication 31, l'étape d'amincissement étant obtenue par polissage ou gravure.

37. Procédé selon l'une des revendications 1 à 36, le premier substrat comportant des zones avec des dopages différents.

## Patentansprüche

1. Verfahren zur Herstellung einer Halbleiterstruktur auf einem Halbleitersubstrat, das an der Oberfläche Motive der Tiefe p aufweist, wobei dieses Verfahren umfasst:
a) - einen Schritt des Bildens einer ersten Schicht (24) aus einem ersten isolierenden Material auf der Oberfläche,
b) - einen Schritt des Bildens einer zweiten Schicht aus einem zweiten isolierenden Material (28), das weniger dicht ist als das erste isolierende Material, auf der ersten Schicht, wobei diese zweite Schicht eine Dicke von weniger als 3,5 mal die Tiefe p hat,
c) - einen Schritt des Abdünnens der Gesamtanordnung.

2. Verfahren nach Anspruch 1, wobei die Topologie durch Motive (22) gebildet ist, die in das Substrat graviert sind und durch Felder (26) getrennt sind.

3. Verfahren nach Anspruch 2, wobei die gravierten Motive (34) eine Tiefe haben, die zwischen 1 mm und 10 µm enthalten ist.

4. Verfahren nach einem der Ansprüche 2 oder 3, wobei die gravierten Motive eine Breite haben, die zwischen 1 µm und 5 mm enthalten ist.

5. Verfahren nach einem der Ansprüche 1 bis 4, wobei das Substrat ein Verbund-Substrat ist.

6. Verfahren nach Anspruch 5, umfassend einen isolierenden Film (21) an der Oberfläche.

7. Verfahren nach einem der Ansprüche 1 bis 6, wobei die erste Isolierschicht (24) eine mit der Topologie des Substrats konforme Schicht ist.

8. Verfahren nach einem der Ansprüche 1 bis 7, wobei der Schritt c) eine Schicht des ersten Isolators (66) auf der Oberfläche übrig lässt.

9. Verfahren nach Anspruch 8, ferner umfassend einen zusätzlichen Abdünnungsschritt, der eine Alternierung von Halbleiterzonen (54) und Isolatorzonen (26) auf der Oberfläche übrig lässt.

10. Verfahren zur Herstellung einer Halbleiterstruktur auf einem Halbleitersubstrat, das Punkte (74) aus einem ersten isolierenden Material aufweist, die bezüglich der Oberfläche des Substrats um eine Höhe h überstehen, wobei dieses Verfahren umfasst:
a) - einen Schritt des Bildens einer Schicht aus einem zweiten isolierenden Material (78), das weniger dicht ist als das erste isolierende Material, auf dem Substrat und den Punkten, wobei diese Schicht eine Dicke von weniger als 3,5 mal die Höhe h hat,
b) - einen Schritt des Abdünnens der Gesamtanordnung.

11. Verfahren nach Anspruch 10, wobei die Punkte in den gravierten Zonen (22) des Halbleitersubstrats gebildet sind.

12. Verfahren nach Anspruch 10 oder 11, wobei die Punkte durch thermische Oxidation des Halbleitersubstrats gebildet werden.

13. Verfahren nach Anspruch 10 oder11, wobei die Punkte durch LPCVD gebildet werden, und die Schicht aus zweitem Isoliermaterial durch PECVD.

14. Verfahren nach einem der Ansprüche 10 bis 13, wobei der Schritt b) eine Schicht (79) aus zweitem Isoliermaterial an der Oberfläche übrig lässt.

15. Verfahren nach einem der Ansprüche 10 bis 13, wobei der Schritt b) an der Oberfläche eine Alternierung von Zonen (78) aus zweitem Isoliermaterial und von Zonen (22) aus erstem Isoliermaterial übrig lässt.

16. Verfahren nach einem der Ansprüche 1 bis 15, wobei dem Schritt des Abdünnens ein Schritt des Verdichtens des zweiten isolierenden Materials vorhergeht.

17. Verfahren nach einem der Ansprüche 1 bis 16, wobei das erste isolierende Material thermisches Si02-Oxid ist.

18. Verfahren nach einem der Ansprüche 1 bis 17, wobei das zweite isolierende Material abgeschiedenes SiO2-Oxid ist.

19. Verfahren nach Anspruch 18, wobei das Oxid durch Dampfphasen-Plasmaabscheidung aufgebracht wird.

20. Verfahren nach einem der Ansprüche 1 bis 19, wobei das isolierende Material aus Al₂O₃ oder aus AlN oder aus SiOn oder aus Si₃N₄ oder aus Diamant oder aus HfO₂ oder aus einem dielektrischen Material mit großer Dielektrizitätskonstante ist.

21. Verfahren nach einem der Ansprüche 1 bis 20, wobei das Halbleitermaterial aus Silizium oder aus Si₁₋ₓGeₓ (0<x<1) ist.

22. Verfahren zur Herstellung einer Halbleiterstruktur, umfassend die Bildung:
a1) - einer ersten Isolierzone in einem Halbleitersubstrat,
b1) - anschließend die Bildung wenigstens einer zweiten Isolierzone in dem gleichen Substrat,
wobei die Schritte a1) und b1) gemäß den Ansprüche 1 bis 21 ausgeführt werden.

23. Verfahren nach Anspruch 22, wobei die Schritte a1) und b1) mit unterschiedlichen Masken ausgeführt werden.

24. Verfahren nach Anspruch 22 oder 23, wobei wenigstens zwei der gebildeten Isolierzonen unterschiedliche Tiefen und/oder Breiten in dem Substrat haben, und/oder aus unterschiedlichen isolierenden Materialien gebildet sind.

25. Verfahren nach einem der Ansprüche 1 bis 24, ferner umfassend einen Schritt des Zusammenfügens mit einem zweiten Substrat (60, 62).

26. Verfahren nach Anspruch 25, wobei das Zusammenfügen durch molekulare Adhäsion durchgeführt wird.

27. Verfahren nach Anspruch 25 oder 26, wobei das zweite Substrat aus einem zweiten Halbleitermaterial ist.

28. Verfahren nach Anspruch 27, wobei das zweite Substrat ferner eine Isolierschicht (64) auf dem zweiten Halbleitermaterial umfasst.

29. Verfahren nach einem der Ansprüche 25 bis 28, wobei ein isolierender Film (65) auf wenigstens einem der zwei Substrate gebildet wird.

30. Verfahren nach einem der Ansprüche 25 bis 29, wobei das erste Substrat wenigstens eine Zone mit einem ersten Leitfähigkeitstyp hat, und das zweite Substrat wenigstens eine Zone mit einem entgegengesetzten Leitfähigkeitstyp hat.

31. Verfahren nach einem der Ansprüche 25 bis 30, ferner umfassend einen Schritt des Abdünnens des ersten und/oder des zweiten Substrats.

32. Verfahren nach Anspruch 31, wobei der Schritt des Abdünnens des einen und/oder des anderen der Substrate durch Bilden einer Fragilisierungsschicht oder -zone realisiert wird.

33. Verfahren nach Anspruch 32, wobei die Fragilisierungsschicht oder -zone mittels einer Schicht aus porösem Silizium realisiert wird.

34. Verfahren nach Anspruch 32, wobei die Bildung einer Fragilisierungsschicht oder -zone durch Ionenimplantation in dem ersten oder dem zweiten Substrat realisiert wird.

35. Verfahren nach Anspruch 34, wobei die implantierten Ionen Wasserstoffionen oder eine Mischung von Wasserstoffionen und Heliumionen sind.

36. Verfahren nach Anspruch 31, wobei der Schritt des Abdünnens durch Polieren oder Gravieren erhalten wird.

37. Verfahren nach einem der Ansprüche 1 bis 36, wobei das erste Substrat Zonen mit unterschiedlichen Dotierungen umfasst.

## Claims

1. A method for producing a semiconducting structure, on a semiconducting substrate having a surface comprising patterns with depth p, this method including:
a) a step for forming a first layer (24) in a first insulating material on said surface,
b) a step for forming a second layer, on the first layer, in a second insulating material (28), less dense than the first insulating material, said second layer having a thickness less than and 3.5 times the depth p,
c) a step for thinning the assembly.

2. The method according to claim 1, the topology being formed by patterns (22) etched in the substrate, separated by trenches (26).

3. The method according to claim 2, the etched patterns (34) having a depth between 1 nm and 10 µm.

4. The method according to any of claims 2 and 3, the etched patterns having a width between 1 µm and 5 mm.

5. The method according to any of claims 1 to 4, the substrate being a composite substrate.

6. The method according to claim 5, including a surface insulating film (21).

7. The method according to any of claims 1 to 6, the first insulator layer (24) being a layer in accordance with the topology of the substrate.

8. The method according to any of claims 1 to 7, step c) leaving a layer of first insulator (66) on the surface.

9. The method according to claim 8, further including an additional thinning step, leaving an alternation of semiconducting areas (54) and of insulating areas (26) on the surface.

10. A method for producing a semiconducting structure, on a semiconducting substrate having pads (74) in a first insulating material protruding with a height h from the surface of the substrate, this method including:
a) a step for forming a second layer, on the substrate and the pads, in a second insulating material (78), less dense than the first insulating material, said layer having a thickness less than and 3.5 times the height h,
b) a step for thinning the assembly.

11. The method according to claim 10, the pads being formed in the etched areas (22) of the semiconducting area.

12. The method according to claim 10 or 11, the pads being formed by thermal oxidation of the semiconducting substrate.

13. The method according to claim 10 or 11, the pads being formed by LPCVD, and the second insulating material layer in PECVD.

14. The method according to any of claims 10 to 13, step b) leaving a second insulating material layer (79) at the surface.

15. The method according to any of claims 10 to 13, step b) leaving at the surface an alternation of second insulating material areas (78) and of first insulating material areas (22).

16. The method according to any of claims 1 to 15, the thinning step being preceded with a step for densifying the second insulating material.

17. The method according to any of claims 1 to 16, the first insulating material being thermal oxide SiO₂.

18. The method according to any of claims 1 to 16, the second insulating material being deposited oxide SiO₂.

19. The method according to claim 18, the oxide being deposited by plasma vapor phase deposition.

20. The method according to any of claims 1 to 19, the insulating material being in Al₂O₃, or AlN, or SiON, or Si₃N₄, or diamond, or HfO₂, or in a dielectric material with a high dielectric constant.

21. The method according to any of claims 1 to 20, the semiconducting material being in silicon or in Si₁₋ₓGeₓ (0<x<1).

22. A method for producing a semiconducting structure, comprising the formation:
a1) of a first insulating area in a semiconducting substrate,
b1) and then the formation of at least a second insulating area in the same substrate,
steps a1) and b1) being carried out according to any of claims 1 to 21.

23. The method according to claim 22, steps a1) and b1) being carried out with different masks.

24. The method according to claim 22 or 23, at least two of the formed insulating areas having different depths and/or widths in the substrate and/or being formed with different insulating materials.

25. The method according to any of claims 1 to 24, further including an assembly step with a second substrate (60, 62).

26. The method according to claim 25, the assembly being achieved by molecular adhesion.

27. The method according to claim 25 or 26, the second substrate being in a second semiconducting material.

28. The method according to claim 27, the second substrate further including an insulator layer (64) on the second semiconducting material.

29. The method according to claims 25 to 28, an insulating film (65) being formed on at least one of the two substrates.

30. The method according to any of claims 25 to 29, the first substrate having at least one area of a first type of conductivity, and the second substrate having at least one area of the opposite conductivity type.

31. The method according to any of claims 25 to 30, further including a step for thinning the first and/or the second substrate.

32. The method according to claim 31, the step for thinning either one or both of the substrates being performed by forming an embrittlement layer or area.

33. The method according to claim 32, the embrittlement layer or area being produced by a layer of porous silicon.

34. The method according to claim 32, the formation of an embrittlement layer or area being produced by ion implantation in the first or second substrate.

35. The method according to claim 34, the implanted ions being hydrogen ions or a mixture of hydrogen ions and helium ions.

36. The method according to claim 31, the thinning step being achieved by polishing or etching.

37. The method according to any of claims 1 to 36, the first substrate including areas with different dopings.
